# EUROPEAN PATENT SPECIFICATION

(11) **EP 0 716 450 B1**
(45) Date of publication and mention of the grant of the patent: **16.08.2001**
(21) Application number: 95308874.7
(22) Date of filing: 07.12.1995
(51) Int. Cl.: H01L 25/07, H01L 23/24

(54) **Semiconductor housing comprising a plurality of chips**
Halbleitergehäuse mit mehreren Chips
Boîtier pour semi-conducteur comprenant plusieurs puces

(30) Priority: 08.12.1994 JP 30493394
(43) Date of publication of application: 12.06.1996
(60) Divisional application: 97119007.9
(73) Proprietor: FUJI ELECTRIC CO. LTD., Kawasaki 210 (JP)
(72) Inventor: Soyano, Shin, c/o Fuji Electric Co. Ltd., Kawasaki-ku, Kawasaki 210 (JP); Toba, Susumu, c/o Fuji Electric Co. Ltd., Kawasaki-ku, Kawasaki 210 (JP)
(74) Representative: Bridge-Butler, Alan James

(56) References cited:
- EP-A- 0 384 482
- EP-A- 0 513 410
- EP-A- 0 609 528

## Description

The present invention relates to semiconductor devices called 'power modules' which house a circuit board on which semiconductor elements are mounted in an insulating casing, and more specifically the present invention relates to a structure for installing a lead pin block on which many lead pins are standing.

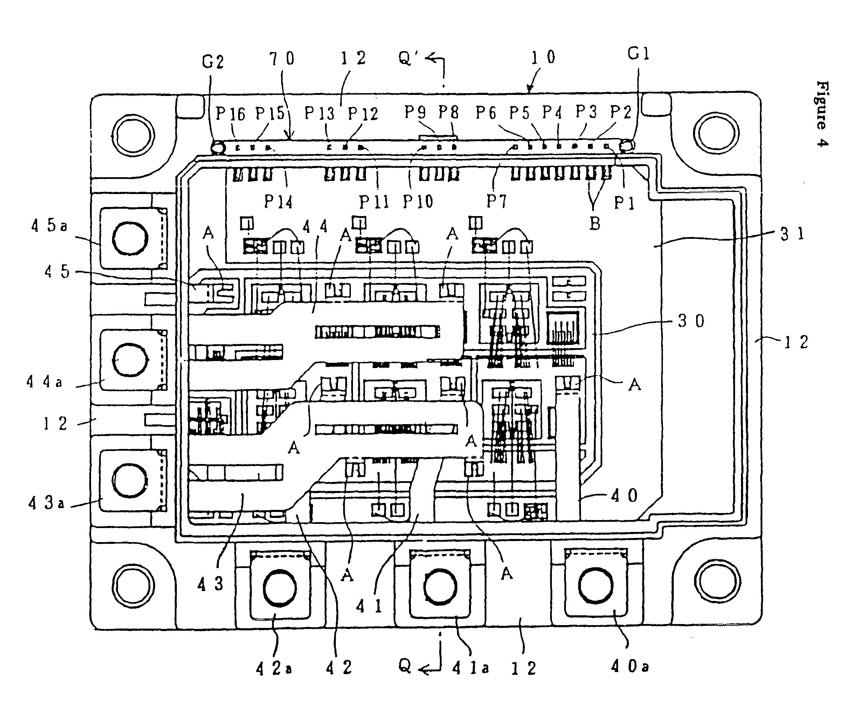

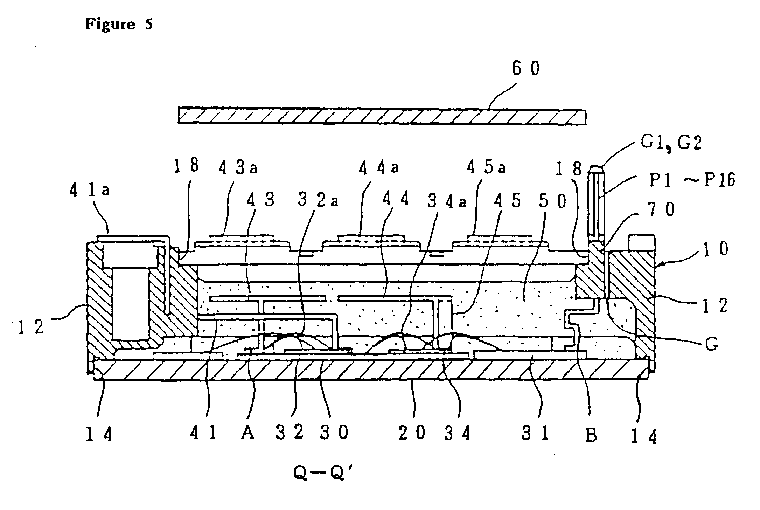

Figure 4 is a top plan view showing a structure of a conventional semiconductor device known as a 'power module' or an 'intelligent power module'. Figure 5 is a cross section along the line Q-Q' of Figure 4. As is shown in these Figures, the semiconductor device has an insulating casing in the form of a frame 12 having opposed end openings and an inner face. A radiator base plate (for example a metal plate) 20 is bonded with an adhesive to a first opening step 14 formed on a first end of the frame 12 to close a first end opening of the casing 10. Circuit boards (ceramics boards) 30, 31 are bonded with a solder etc. to the interior face of the radiator base plate 20. Lead frames 40 to 45 are connected at their inner lead ends A to the land areas of the thick film wiring formed on the circuit board 30. A lead pin block 70, integrally formed with many lead pins P1 to P16 standing thereon, is fixed to the frame 12 of the insulating casing 10. The ends B of inner leads of the respective lead pins P1 to P16 are connected with thick film wiring formed on the circuit board 31. The circuit board 30, the inner leads of the lead frames 40 to 45, and the inner leads of the lead pins P1 to P16 are immersed in a gel resin sealant 50 such as silicone resin. An insulating cover plate 60 is bonded with an adhesive to a second opening step 18 formed on the second end of the frame 12 to close the second end opening of the casing 10. Semiconductor elements (chips) 32, 34 such as power transistors, IGBTs (conductivity modulation type transistors), diodes, thyristors, etc. are mounted on the circuit boards 30, 31. The inner lead ends A of the lead frames 40 to 45 are bonded with solder or the like to land portions of the thick film wiring of the circuit board 30, and connected through bonding wires 32a and 34a to the corresponding semiconductor elements 32 and 34.

The lead frames 40 to 45 are inserted into the frame 12 and fixed to the frame 12 at respective terminal washers 40a to 45a with terminal screws (not shown).

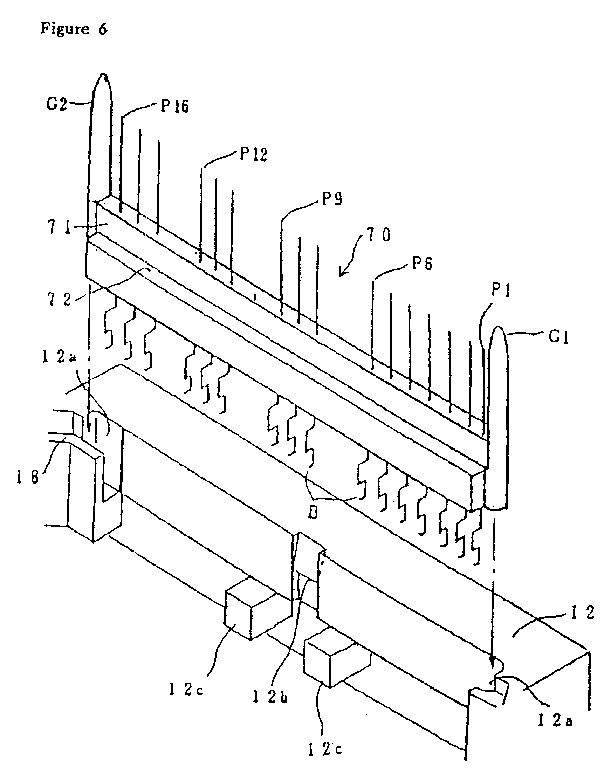

Figure 6 is an exploded isometric view showing the lead pin block and its installation structure. Referring now to Figure 6, the lead pin block 70 is an insert moulding, moulded separately from the insulating casing 10. The lead pin block 70 includes a base 71 on which the lead pins P1 to P16 stand, a step 72, a coupling claw (not shown) formed on the opposite side to the face on which the step 72 is formed, and guide pins G1 and G2. The upper face of the step 72 is positioned at the same height as the upper face of the second end opening step 18, when the guide pins G1 and G2 are inserted into respective slots 12a formed on the inner face of the frame 12 of the insulating casing 10, so as to accept the insulating cover plate 60. The coupling claw couples with a wedge-shaped coupling claw 12b formed on the inner face of the frame 12 to resist removal of the lead pin block once inserted. The guide pins G1 and G2 are inserted into respective guide holes formed on a female connector for the lead pins P1 to P16 (not shown). A pair of support pins 12c which locate and sustain the inserted lead pin block 70 at the predetermined height, are formed on the inner face of the frame 12. The lead pin block is moulded separately from the insulating casing 10 to reduce the volume of the resin moulding, and thus to minimise the influence of the shrinkage etc. of the resin. By this means, both the precision of the pitch between the lead pins and the verticalness of the lead pins P1 to P16 are improved, and therefore, the production yield of the semiconductor device is improved.

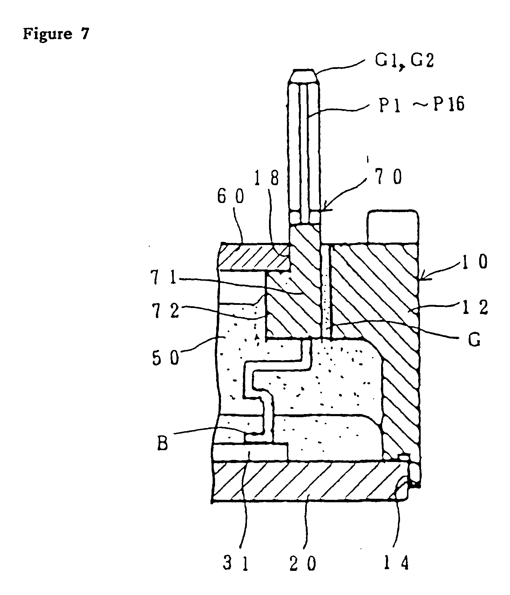

The lead pin block 70 is installed on the insulating casing 10 tightly enough so as not to come out easily by inserting the lead pin block 70 into the slots 12a, and by coupling together the coupling claw 12b of the frame 12 and the coupling claw of the lead pin block 70. Figure 7 is a partial cross section of the insulating casing with the lead pin block installed thereon. As shown in Figure 7, the insulating casing 10 is filled with the gel resin sealant 50 (such as silicone resin), and is then closed by the insulating cover plate 60, which is bonded with an adhesive to the second end opening step 18 of the insulating casing 10 and to the step 72 of the lead pin block 70.

The above described structure for installing the lead pin block 70 on the semiconductor module has the disadvantage that the gel resin sealant (silicone resin) 50 is heated up and expands due to the heating applied for bonding the insulating cover plate 60 to the insulating casing 10 or by the heat generated from the power elements of the operating semiconductor module, immersed in the gel resin sealant 50. The expanding gel resin sealant 50 spreads out through the insertion gap G between the base 71 of the lead pin block 70 and the inner face of the frame 12 or lifts up the insulating cover plate 60.

Another drawback is that since the lead pins P1 to P16 are extremely fine square rods less than 1 mm in width, the lead pins are easily bent by any unwanted contact etc. during packaging or transportation of the semiconductor module. Furthermore, the resin guide pins G1 and G2 are easily broken.

EP-A-0 591 631 discloses a conventional semiconductor device.

In view of the foregoing, it is an object of the invention to provide a semiconductor device according to claim 1 with an installation structure for installing a lead pin block which prevents the gel resin sealant from spreading out through the insertion gap between the base of the lead pin block and the inner face of the frame.

The semiconductor device of the invention can also be provided with a protective structure which prevents the lead pins and guide pins from bending or breaking during the transport and handling of the semiconductor device.

According to the present invention a semiconductor device comprises an insulating casing 10 in the form of a frame 12 and having opposed end openings and an inner face; a separately formed lead pinblock 80 having a base 81 with a plurality of lead pins P1-P16 standing thereon, the lead pin block 80 being installed on the inner face of the frame, and the lead pins P1-P16 having respective inner leads; a radiator base plate 20 closing a first end opening of the insulating casing; a circuit board 30,31 whereon are mounted semiconductor chips 32,34 connected to the ends B of the inner leads, the circuit board 30,31 being bonded to the interior face of the radiator base plate 20; a gel resin sealant 50 in which the circuit board 30,31 and the inner leads are immersed, the gel resin sealant 50 substantially filling the inner space of the insulating casing 10; an insulating cover plate 60 closing the second end opening of the insulating casing 10; and a sealant 85 closing an insertion gap G between the lead pin block 80 and the frame 12; characterised by an air vent 83 leading from the inner space of the casing and formed through the base 31 of the lead pin block 80, above the level of the gel resin sealant 50.

Preferably the lead pin block 80 includes a first coupling claw 81a having a latch portion 81b, and the frame includes a second coupling claw 12b formed on the inner face thereof, the first and second coupling claws being coupled with one another, and in that said air vent 83 is formed across the latch portion of the first coupling claw 81a.

The lead pin block base can have guide pins on both sides of the lead pins and a sheath block can be provided having a plurality of lead holes h1 to h22 and a plurality of guide holes H1,H2, the lead pins P1-P16 and the guide pins G1,G2 being freely insertable into and removable from the lead holes h1 to h22 and guide holes H1,H2 respectively.

It is preferable to form stopper protrusions on the base of the lead pin block so as to limit the insertion depth of the sheath block.

Steps can be formed on the contact face of the sheath block in the vicinity of the guide holes.

Moreover the sheath block can be provided with a first guide hole located on a first end thereof, a second guide hole located on a second end thereof, a third guide hole located midway in the alignment of the lead pins, and at least one weakened section provided by a recess for partitioning located in the vicinity of the third guide hole.

The insertion gap between the lead pin block and the frame is closed on the interior side of the casing when the lead pin block is installed on the casing. The gel resin sealant, although it may be heated and expanded by the heat generated from the semiconductor elements, never spreads out through the insertion gap. As the gel resin sealant thermally expands, the air pressure in the inner space tends to rise. However, the air vent prevents the inner pressure from rising, and the free surface level of the gel resin sealant rises with no problems. Thus, excessive thermal stress and lifting up of the insulating cover plate are prevented, and the reliability of the semiconductor device is improved. The air vent is preferably formed across the step portion of the first coupling claw so that the air vent can communicate to the outside through the gap of the second coupling claw formed on the side of the casing. The lead pin block which has the air vent formed therein is manufactured by insertion moulding without using a moving core mould, by forming the air vent across the step portion of the first coupling claw of the thus moulded lead pin block. Since a moving core mould is avoided, the manufacturing cost of the semiconductor device is reduced.

The lead pins and the guide pins are completely covered by the sheath block by inserting the sheath block onto the lead pins and the guide pins. The sheath block avoids anything from coming into direct contact with the pins during transport and prevents the pins from bending or breaking. The stopper protrusions are formed on the upper face of the base of the lead pin block to limit the extent to which the sheath block can be pushed onto the lead pins, to secure a minimum clearance distance between the pins of circuit terminal groups on one side of an arm. When the sheath block is inserted, the contact face touches the stopper protrusions leaving a gap around the roots of the pins. This gap facilitates pulling out the inserted sheath block. When a guide pin is broken, the broken guide pin is repaired by bonding with an adhesive. However, the adhesive sometimes spreads away from the repaired guide pin and solidifies at locations which make it difficult to insert the sheath block completely. The relief space for the spreading adhesive, formed by the provision of the steps on the contact face of the sheath block adjacent to the respective guide holes, facilitates inserting the sheath block completely. By using the sheath block which has the third guide hole and at least one recess for partitioning, guide blocks having different number of lead pins can easily be accommodated. This type of sheath block is divided along the recess when the counterpart lead block has a smaller number of lead pins.

The preferred embodiments of the present invention will now be explained in detail with reference to the accompanying drawings, in which:
Figure 1(a) is a cross-section of a first embodiment of a semiconductor device according to the present invention;
Figure 1(b) is a partial cross section showing the installation structure for the lead pin block of Figure 1(a);
Figure 2 is an exploded isometric view showing the installation structure for the lead pin block of the present invention;
Figure 3(a) is a top plan view of a second sheath block;
Figure 3(b) is a front view of the sheath block of Figure 3(a);
Figure 4 is a top plan view showing a structure of a conventional semiconductor device called a 'power module' or an 'intelligent power module';
Figure 5 is a cross section along Q-Q' of Figure 4;
Figure 6 is an exploded isometric view showing the lead pin block and its installation structure according to the prior art; and
Figure 7 is a partial cross section of the insulating casing with the lead pin block installed thereon according to the prior art.

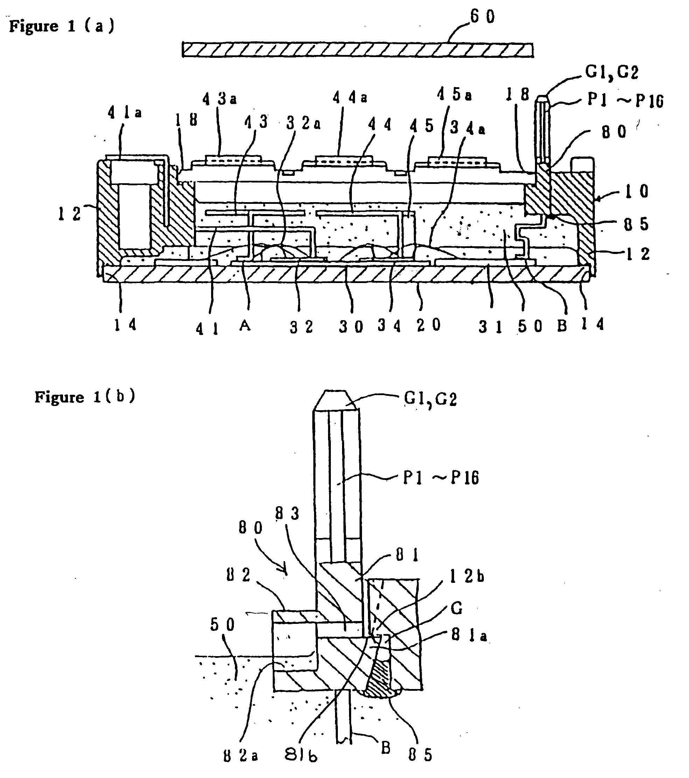

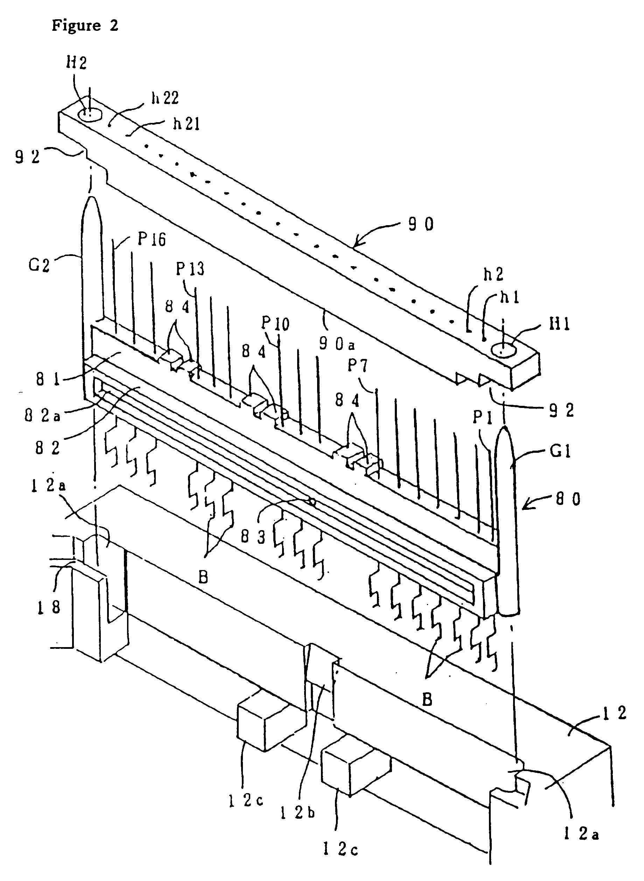

Referring now to the Figures, Figure 1(a) is a cross section of a first embodiment of a semiconductor device according to the present invention. Figure 1(b) is a partial cross section showing the installation structure for the lead pin block of Figure 1(a), and Figure 2 is an exploded isometric view showing the installation structure for the lead pin block and the sheath block of the present invention.

The semiconductor device of the invention is called a 'power module' or an 'intelligent power module' and has a two-dimensional layout similar to that shown in Figure 4. Referring now to Figures 1(a) and 1(b), the semiconductor device of the invention has an insulating casing 10 in the form of a frame 12 having opposed end openings and an inner face. A heat-dissipating base plate 20 (preferably a metal plate) is bonded with an adhesive to a first end opening rebate or step 14 formed on the first end of the frame 12, to close the first end opening of the casing 10. Circuit boards (ceramics boards) 30, 31 are bonded with for example solder etc. to the interior face of the base plate 20. Lead frames 40 to 45 are connected at their inner lead ends A to the thick film wiring formed on the circuit board 30. The lead frames 41, 43, 44 and 45 are shown in Figure 1(a). A lead pin block 80, which is an insert moulding integrated with lead pins P1 to P16 standing thereon, is fixed to the frame 12 of the insulating casing 10. The ends B of inner leads of the respective lead pins P1 to P16 are connected with thick film wiring formed on the circuit board 31. The circuit board 30, the inner leads of the lead frames 40 to 45, and the inner leads of the lead pins P1 to P16 are immersed in a gel resin sealant (for example silicone resin) 50. An insulating cover plate 60 is bonded with an adhesive to a second end opening step 18 formed on the second end of the frame 12 to close the second end opening of the casing 10. Semiconductor elements (chips) 32, 34 such as power transistors, IGBTs (conductivity modulation type transistors), diodes, thyristors, etc. are mounted on the circuit boards 30 and 31. The inner lead ends A of the lead frames 40 to 45 are bonded for example by soldering etc. to the land portions of the thick film wiring of the circuit board 30, and are connected through bonding wires 32a and 34a to the corresponding semiconductor elements 32 and 34. The lead frames 40 to 45 are inserted into and fixed to the frame 12 at respective terminal washers 40a to 45a with terminal screws (not shown).

Referring now to Figure 1(b) and Figure 2, the lead pin block 80 is an insert moulding moulded separately from the insulating casing 10. The lead pin block 80 includes a base 81 on which the lead pins P1 to P16 stand; a step 82; a first coupling claw 81a having a latch portion 81b formed on the opposite face of the base 81 to the face on which the step 82 is formed; guide pins G1 and G2; an air vent 83 formed through the base 81 from a recess 82a of the step 82 to the latch portion 81b of the coupling claw 81; and a plurality of stopper protrusions 84 formed on the upper face of the base 81. The upper face of the step 82 is positioned at the same height as the upper face of the second opening step 18, when the guide pins G1 and G2 are inserted into respective slots 12a formed on the inner face of the frame 12 of the insulating casing 10, so as to accept the insulating cover plate 60. The coupling claw 81a couples with a wedge-shaped coupling claw 12b formed on the inner face of the frame 12 (see Figure 1(b)). The guide pins G1 and G2 are inserted into respective guide holes formed on a female connector for the lead pins P1 to P16 (not shown).

The lead pin block 80 is installed on the insulating casing 10 tightly enough so as not to come out easily, by inserting the lead pin block 80 into the slots 12a and by coupling the coupling claw 12b of the frame 12 and the coupling claw 81a of the lead pin block 80 with one another. In this embodiment, the insertion gap G between the lead pin block 80 and the frame 12 is closed with a sealant or adhesive etc. 85 on the side of the interior space of the casing 10, which communicates to the outside through the air vent 83.

Thus, the insertion gap G between the lead pin block 80 and the frame 12 is closed on the side of the interior space of the casing 10 in that the lead pin block 80 is inserted into the slots 12a and installed on the casing 10. The gel resin sealant 50, although it may be heated and expanded by the heat generated from the semiconductor chips 32 and 34, never spreads out through the gap G. As the gel resin sealant 50 thermally expands, the air pressure in the interior tends to rise. However, the air vent 83 prevents the internal pressure from rising, and the free surface level of the gel resin sealant 50 rises with no problems as the gel expands. Thus, excessive thermal stress and lifting up of the insulating cover plate 60 are prevented, and the reliability of the semiconductor device is improved. In this embodiment, the air vent 83 is formed across the latch portion 81b of the coupling claw 81a so that the air vent can communicate with the outside through the gap of the coupling claw 12b formed on the side of the casing 10. The lead pin block 80 with the air vent 83 formed therein is manufactured by injection moulding in a simple mould with no moving cores, by forming the air vent 83 across the step portion of the coupling claw 81a of the thus moulded lead pin block. Since the mould construction is simplified, the manufacturing cost of the semiconductor device is reduced.

As shown in Figure 2, a sheath block 90 made of resin has lead holes h1 to h22 corresponding to the lead pins P1 to P16 and guide holes H1 and H2 corresponding to the guide pins G1 and G2. The lead pins P1 to P16 are freely insertable into and removable from the lead holes h1 to h22. The guide pins G1 and G2 are freely insertable into and removable from the guide holes H1 and H2. And, double-steps 92, 92, respectively having two steps thereon, are formed on a contact face 90a of the sheath block 90 on the sides of the respective guide holes H1 and H2.

The lead pins and the guide pins are completely covered by a sheath block, by inserting a sheath block 90 onto the lead pins P1 to P16 and the guide pins G1 and G2. The sheath block 90 prevents anything from coming into direct contact with the pins during the transport and prevents the pins from bending or breaking. Stopper protrusions 84 are formed on the upper face of the base 81 of the lead pin block 80 to define the distance between the circuit terminal groups of one side of an arm. When the sheath block 90 is inserted, a contact face 90a touches the stopper protrusions 84 leaving a gap around the roots of the pins. The gap between the sheath block and the base 81 facilitates the removal of the inserted sheath block 90.

If either guide pin G1 or G2 is broken, the broken guide pin is repaired by bonding its parts back together with an adhesive. However, the adhesive sometimes spreads away from the repaired guide pin and sticks to the adjacent areas of the base 81, making it difficult to insert the sheath block completely. To avoid this problem, double steps 92 are formed on the contact face 90a of the sheath block 90 to the sides of the respective guide holes H1 and H2 so as to provide a relief space to accommodate any excess adhesive. Thus, the sheath block 90 can be inserted easily onto a repaired guide pin.

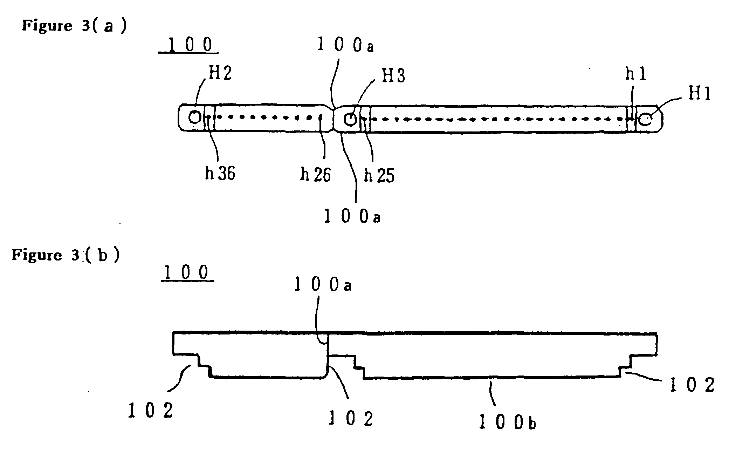

Figure 3(a) is a top plan view of another sheath block, and Figure 3(b) is a front plan view of the sheath block of Figure 3(a). This sheath block 100 has a first guide hole H1 formed on an end of the sheath block 100, a second guide hole H2 formed on another end of the sheath block 100, and a third guide hole H3 formed at a location midway in the alignment of guide holes P1 to P36. The guide holes P1 to P25 are aligned between the first guide hole H1 and the third guide hole H3. Recesses 100a for partitioning are formed on the front and rear faces of the sheath block 100 between the third guide hole H3 and the guide pin 26. Double steps (like steps 92) are formed on a contact face 100b of the sheath block 100 near the guide holes H1 and H2 and H3.

This sheath block 100 copes with lead pin blocks having different number of lead pins thereon. For protecting a lead pin block having 36 lead pins thereon, the sheath block 100 is used in the state as shown in Figures 3(a) and 3(b). For protecting a lead pin block having 25 lead pins thereon, the sheath block 100 is divided by snapping the weakened section between the recesses 100a, 100a, and the portion that has the guide holes H1 and H3 is used. Thus, the sheath block 100 facilitates reducing the cost of the mould.

As has been explained above, the semiconductor device of the invention comprises a lead pin block having an air vent formed therein and can also include a sheath block that covers and protects the pins standing on the lead pin block. Consequently, the semiconductor device of the invention has the following effects:

Since the insertion gap between the lead pin block and the frame is closed with a sealant on the interior side of the casing, the gel resin sealant which is heated and expanded by the heat generated in the semiconductor chips never spreads out through the insertion gap. Since the air vent prevents the internal pressure from rising, and since the free surface level of the gel resin sealant can rise with no problems as the gel expands, excessive thermal stress and lifting up of the insulating cover plate 60 are prevented.

By forming the air vent across the latch portion of the coupling claw of the lead pin block that couples with the coupling claw of the casing, the lead pin block is manufactured easily with reduced cost by moulding the lead pin block without using a moving core mould.

Since the lead pins and the guide pins of the lead pin block are completely covered by the sheath block when the sheath block is placed onto the lead pins and the guide pins, the pins are protected from contact, deformation, and breaking during the transport.

Provision of the stopper protrusions formed on the upper face of the base of the lead pin block means that a gap is left around the roots of the pins, and thus the inserted sheath block may be easily removed.

Since a relief space for the spreading adhesive is left by forming the double-steps, respectively having two steps thereon, on the contact face of the sheath block adjacent to the respective guide holes, complete insertion of the sheath block is facilitated even when broken guide pins have been repaired by adhesive bonding.

By using the sheath block that has the third guide hole and recesses for partitioning, it is possible to cope with guide blocks having different numbers of lead pins. This type of sheath block is divided along the recesses when the lead block to which it is to be applied has a lesser number of lead pins.

## Claims

1. A semiconductor device comprising :
an insulating casing (10) in the form of a frame (12) and having opposed end openings and an inner face;
a lead pin block (80) having a base (81) with a plurality of lead pins (P1-P16) standing thereon, the lead pin block (80) being installed on the inner face of the frame, and the lead pins (P1-P16) having respective inner leads;
a radiator base plate (20) closing a first end opening of the insulating casing;
a circuit board (30,31) whereon are mounted semiconductor chips (32,34) connected to the ends (B) of the inner leads, the circuit board (30,31) being bonded to the interior face of the radiator base plate (20);
a gel resin sealant (50) in which the circuit board (30,31) and the inner leads are immersed, the gel resin sealant (50) substantially filling the inner space of the insulating casing;
an insulating cover plate (60) closing the second end opening of the insulating casing (10); and
a sealant (85) closing an insertion gap (G) between the lead pin block (80) and the frame (12); characterised by
an air vent (83) leading from the inner space of the casing and formed through the base (31) of the lead pin block (80).

2. A semiconductor device as claimed in claim 1 characterised in that the lead pin block (80) includes a first coupling claw (81a) having a latch portion (81b), and the frame includes a second coupling claw (12b) formed on the inner face thereof, the first and second coupling claws being coupled with one another, and in that said air vent (83) is formed across the latch portion of the first coupling claw (81a).

3. A semiconductor device as claimed in claim 1 or claim 2 characterised in that the lead pin block base (81) has guide pins (G1,G2) on both sides of the lead pins (P1-P16) and a sheath block (90) is provided having a plurality of lead holes (h1 to h22) and a plurality of guide holes (H1,H2), the lead pins (P1-P16) and the guide pins (G1,G2) being freely insertable into and removable from the lead holes (h1 to h22) and guide holes (H1,H2) respectively.

4. A semiconductor device as claimed in claim 3 characterised in that stopper protrusions (84) are formed on the base (81) of the lead pin block (80) to limit the insertion depth of the sheath block (90).

5. A semiconductor device as claimed in claim 3 or claim 4 characterised in that steps (92) are formed on the contact face (90a) of the sheath block (90) in the vicinity of the guide holes (H1,H2).

6. A semiconductor device as claimed in claim 3, claim 4 or claim 5 characterised in that the sheath block (90) has a first guide hole (H1) located on a first end thereof, a second guide hole (H2) located on a second end thereof, a third guide hole (H3) located midway in a line of the lead pins (P1-P16), and at least one weakened section provided by a recess (100a) for partitioning located in the vicinity of the third guide hole (H3).

## Patentansprüche

1. Halbleiterbauelement mit:
einem Isolationsgehäuse (10) in Form eines Rahmens (12) und mit entgegengesetzten Stirnöffnungen und einer Innenfläche;
einem Zuleitungsstiftblock (80) mit einem Sockel (81) mit einer Vielzahl von darauf stehenden Zuleitungsstiften (P1-P16), wobei der Zuleitungsstiftblock (80) an der Innenfläche des Rahmens installiert ist und die Zuleitungsstifte (P1-P16) jeweilige innere Zuleitungen aufweisen;
einer Radiatorgrundplatte (20), die eine erste Stirnöffnung des Isolationsgehäuses verschließt;
einer Leiterplatte (30, 31), auf der Halbleiterchips (32, 34) montiert sind, die mit den Enden (B) der inneren Zuleitungen verbunden sind, wobei die Leiterplatte (30, 31) an die Innenfläche der Radiatorgrundplatte (20) gebondet ist;
einem Gelharzdichtungsmaterial (50), in das die Leiterplatte (30, 31) und die inneren Zuleitungen eingetaucht sind, wobei das Gelharzdichtungsmaterial (50) den Innenraum des Isolationsgehäuses im wesentlichen ausfüllt;
einer Isolationsdeckplatte (60), die die zweite Stirnöffnung des Isolationsgehäuses (10) verschließt; und
einem Dichtungsmaterial (85), das einen Einsetzspalt (G) zwischen dem Zuleitungsstiftblock (80) und dem Rahmen (12) verschließt; gekennzeichnet durch
eine Entlüftungsöffnung (83), die aus dem Innenraum des Gehäuses führt und durch den Sockel (31) [(81)] des Zuleitungsstiftblocks (80) hindurch ausgebildet ist.

2. Halbleiterbauelement nach Anspruch 1, dadurch gekennzeichnet, daß der Zuleitungsstiftblock (80) eine erste Kopplungsklaue (81a) mit einem Verriegelungsteil (81b) umfaßt und der Rahmen eine zweite Kopplungsklaue (12b) umfaßt, die an dessen Innenfläche ausgebildet ist, wobei die erste und die zweite Kopplungsklaue miteinander gekoppelt sind, und daß die Entlüftungsöffnung (83) über den Verriegelungsteil der ersten Kopplungsklaue (81a) ausgebildet ist.

3. Halbleiterbauelement nach Anspruch 1 oder Anspruch 2, dadurch gekennzeichnet, daß der Zuleitungsstiftblock-Sockel (81) Führungsstifte (G1, G2) auf beiden Seiten der Zuleitungsstifte (P1-P16) aufweist und ein Mantelblock (90) mit einer Vielzahl von Zuleitungslöchern (h1 bis h22) und einer Vielzahl von Führungslöchern (H1, H2) vorgesehen ist, wobei die Zuleitungsstifte (P1-P16) und die Führungsstifte (G1, G2) frei in die Zuleitungslöcher (h1 bis h22) bzw. die Führungslöcher (H1, H2) einsetzbar und aus diesen herausnehmbar sind.

4. Halbleiterbauelement nach Anspruch 3, dadurch gekennzeichnet, daß Anschlagvorsprünge (84) auf dem Sockel (81) des Zuleitungsstiftblocks (80) ausgebildet sind, um die Einsetztiefe des Mantelblocks (90) zu begrenzen.

5. Halbleiterbauelement nach Anspruch 3 oder Anspruch 4, dadurch gekennzeichnet, daß Stufen (92) auf der Kontaktfläche (90a) des Mantelblocks (90) in der Nähe der Führungslöcher (H1, H2) ausgebildet sind.

6. Halbleiterbauelement nach Anspruch 3, Anspruch 4 oder Anspruch 5, dadurch gekennzeichnet, daß der Mantelblock (90) ein erstes Führungsloch (H1), das sich an einem ersten Ende desselben befindet, ein zweites Führungsloch (H2), das sich an einem zweiten Ende desselben befindet, ein drittes Führungsloch (H3), das sich auf halbem Weg in einer Linie der Zuleitungsstifte (P1-P16) befindet, und mindestens einen geschwächten Abschnitt, der durch eine Aussparung (100a) zum Aufteilen vorgesehen ist, die sich in der Nähe des dritten Führungslochs (H3) befindet, aufweist.

## Revendications

1. Dispositif à semi-conducteurs, comprenant :
un boîtier isolant (10) sous la forme d'un cadre (12) et ayant des ouvertures d'extrémités opposées et une face interne ;
un bloc (80) de broches de connexion ayant une base (81) dont font saillie une pluralité de broches de connexion (P1-P16), le bloc (80) de broches de connexion étant installé sur la face interne du cadre, et les broches de connexion (P1-P16) ayant des conducteurs intérieurs respectifs ;
un socle (20) de radiateur fermant une première ouverture d'extrémité du boîtier isolant ;
une carte (30, 31) de circuit sur laquelle sont montées des puces à semi-conducteurs (32, 34) connectées aux extrémités (B) des conducteurs intérieurs, la carte (30, 31) de circuit étant collée à la face interne du socle (20) de radiateur ;
une résine gélifiée d'étanchéité (50) dans laquelle la carte (30, 31) de circuit et les conducteurs intérieurs sont immergés, la résine gélifiée d'étanchéité (50) remplissant sensiblement l'espace intérieur du boîtier isolant ;
un capot isolant (60) fermant la seconde ouverture d'extrémité du boîtier isolant (10) ; et
un agent d'étanchéité (85) fermant un intervalle d'insertion (G) entre le bloc (80) de broches de connexion et le bâti (12) ; caractérisé par
un orifice de mise à l'air libre (83) débouchant de l'espace intérieur du boîtier et formé à travers la base (81) du bloc (80) de broches de connexion.

2. Dispositif à semi-conducteurs selon la revendication 1, caractérisé en ce que le bloc (80) de broches de connexion comporte une première griffe d'accouplement (81a) ayant une partie de verrouillage (81b), et le cadre comporte une seconde griffe d'accouplement (12b) formée sur la face interne de celui-ci, la première et seconde griffes d'accouplement étant accouplées l'une avec l'autre, et en ce que ledit orifice de mise à l'air libre (83) est formé à travers la partie d'accrochage de la première griffe d'accouplement (81a).

3. Dispositif à semi-conducteurs selon la revendication 1 ou la revendication 2, caractérisé en ce que la base (81) du bloc de broches de connexion (81) comporte des broches de guidage (G1, G2) de part et d'autre des broches de connexion (P1-P16) et un bloc de protection (90) muni d'une pluralité de trous de connexion (h1 à h22) et d'une pluralité de trous de guidage (H1, H2), les broches de connexion (P1-P16) et les broches de guidage (G1, G2) pouvant respectivement être librement insérées dans et extraites des trous de connexion (h1 à h22) et les trous de guidage (H1, H2).

4. Dispositif à semi-conducteurs selon la revendication 3, caractérisé en ce que des saillies d'arrêt (84) sont formées sur la base (81) du bloc (80) de broches de connexion pour limiter la profondeur d'insertion du bloc de protection (90).

5. Dispositif à semi-conducteurs selon la revendication 3 ou la revendication 4, caractérisé en ce que des gradins (92) sont formés sur la face de contact (90a) du bloc de protection (90) au voisinage des trous de guidage (H1, H2.

6. Dispositif à semi-conducteurs selon la revendication 3, la revendication 4 ou la revendication 5, caractérisé en ce que le bloc de protection (90) a un premier trou de guidage (H1) situé en une première extrémité de celui-ci, un deuxième trou de guidage (H2) situé en une seconde extrémité de celui-ci, un troisième trou de guidage (H3) situé à mi-distance sur une ligne des broches de connexion (P1-P16), et au moins une partie affaiblie constituée par un évidement (100a) de séparation situé au voisinage du troisième trou de guidage (H3).
